Europäisches Patentamt

European Patent Office

Office européen des brevets

(19)

(11) Veröffentlichungsnummer: **0 239 773**
**A1**

(12) **EUROPÄISCHE PATENTANMELDUNG**

(21) Anmeldenummer: **87102437.8**

(22) Anmeldetag: **20.02.87**

(51) Int. Cl.⁴: **G01N 24/04 , G01N 24/08**

(30) Priorität: **05.03.86 DE 3607274**

(43) Veröffentlichungstag der Anmeldung:
**07.10.87 Patentblatt 87/41**

(84) Benannte Vertragsstaaten:
**DE FR GB**

(71) Anmelder: **Siemens Aktiengesellschaft Berlin und München**
**Wittelsbacherplatz 2**
**D-8000 München 2(DE)**

(72) Erfinder: **Bachus, Reiner, Dr.**
**Obere Bück 8**
**D-8520 Buckenhof(DE)**
Erfinder: **Brill, Günter, Dr.**
**Löschpfad 23**
**D-6685 Schiffweiier(DE)**
Erfinder: **Deimling, Michael, Dr.**
**Ziegeleistrasse 12a**
**D-8550 Forchheim(DE)**

(54) **Kernspin-Tomographiegerät.**

(57) Das erfindungsgemäße Kernspin-Tomographiegerät dient zur bildlichen Darstellung von Bereichen aus dem Inneren eines Untersuchungsobjekts (5) mit Mitteln (1 bis 9) zum Anlegen von magnetischen Grund-und Gradientenfeldern an das Untersuchungsobjekt (5) zur Auslenkung der Kernspins des Untersuchungsobjekts (5) aus ihrer Gleichgewichtslage durch hochfrequente Anregungsimpulse. Ferner ist eine Meßvorrichtung für Kernresonanzsignale vorhanden, die durch Relaxation der angeregten Kernspins entstehen. Die Kernresonanzsignale werden dem Untersuchungsobjekt unmittelbar galvanisch entnommen. Das Untersuchungsobjekt wird Teil der Empfangsantenne oder deren Zuleitung. Dadurch können Hochfrequenzspulen zur Erfassung der Kernresonanzsignale entfallen.

FIG 2

EP 0 239 773 A1

## Kernspin-Tomographiegerät

Die Erfindung betrifft ein Kernspin-Tomographiegerät zur bildlichen Darstellung von Bereichen aus dem Inneren eines Untersuchungsobjektes mit Mitteln zum Anlegen von magnetischen Grund-und Gradientenfeldern an das Untersuchungsobjekt und zur Auslenkung der Kernspins des Untersuchungsobjekts aus ihrer Gleichgewichtslage durch hochfrequente Anregungsimpulse sowie mit einer Meßeinrichtung zur Erfassung der durch Spinpräzession erzeugten Signale.

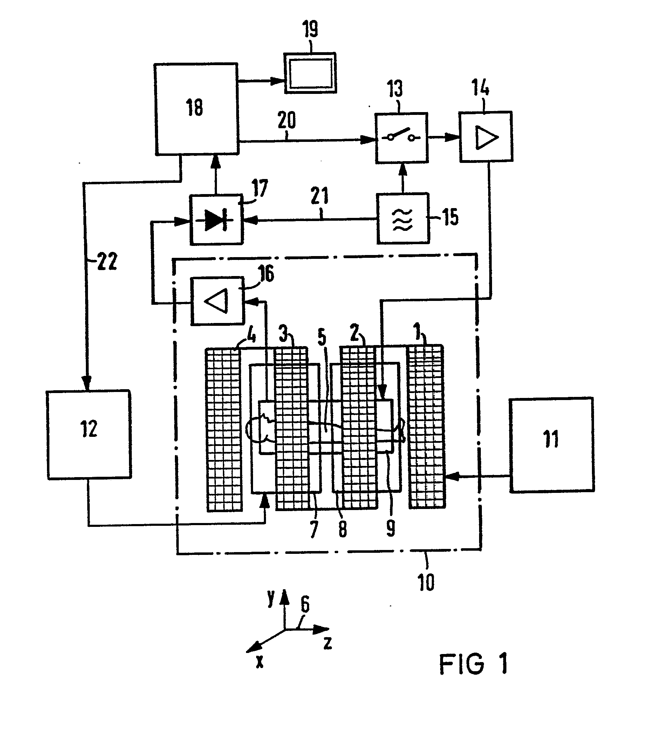

Ein derartige Einrichtung ist beispielsweise aus der DE-OS 33 40 523 bekannt. Zur Erläuterung der Problemstellung wird diese bekannte Einrichtung anhand der Fig. 1 näher erläutert.

In der Fig. 1 sind mit 1 und 2 sowie mit 3 und 4 Spulen gekennzeichnet, mit welchen ein magnetisches Gleichfeld $B_0$ erzeugt wird, in welchem sich bei Anwendung zur medizinischen Diagnostik der zu untersuchende Körper 5 eines Patienten befindet. In den Spulen 1 bis 4 sind außerdem Gradientenspulen vorgesehen, die zur Erzeugung unabhängiger, zueinander senkrechter Magnetfeldgradienten der Richtungen X, Y und Z gemäß einem in Fig. 1 mit 6 bezeichneten Koordinatensystem vorgesehen sind. In Fig. 1 sind der Übersichtlichkeit halber nur Gradientenspulen 7 und 8 gezeichnet, die zusammen mit einem Paar gegenüberliegender gleichartiger Gradientenspulen zur Erzeugung eines X-Gradienten dienen. Die gleichartigen, nicht gezeichneten Y-Gradientenspulen liegen parallel zum Körper 5 und oberhalb sowie unterhalb von ihm. Die Gradientenspulen für das Z-Gradientenfeld liegen quer zur Längsachse des Körpers 5 am Kopf-und am Fußende. Die Anordnung enthält außerdem noch eine Hochfrequenzspule 9, die gleichzeitig zur Anregung der Kernresonanz und zur Aufnahme der Kernresonanzsignale dient.

Die von einer strichpunktierten Linie 10 umgrenzten Spulen 1 bis 9, die das eigentliche Untersuchungsinstrument darstellen, werden mit einer elektrischen Anordnung betrieben, die ein Netzgerät 11 zum Betrieb der Spulen 1 bis 4 sowie eine Gradientenstromversorgung, an welcher die Gradientenspulen 7 und 8 sowie die weiteren, nicht dargestellten Gradientenspulen liegen, umfaßt. Die sowohl zur Anregung als auch zur Aufnahme des Signals dienende Hochfrequenzspule 9 liegt einerseits über einen Modulator 13 und einen Sendeverstärker 14 an einem Hochfrequenzoszillator 15 und andererseits über einen Signalverstärker 16 und einen phasenempfindlichen Gleichrichter 17 an einem Prozeßrechner 18, von dem aus zur Ausgabe der Abbildung ein Bildschirmgerät 19 versorgt wird. Zur Steuerung der Anordnung sind außerdem noch Verbindungen 20, 21 und 22 zwischen dem Rechner 18 und dem Modulator 13, dem Oszillator 15 und dem Gleichrichter 17, sowie dem Rechner 18 und der Gradientenstromversorgung 12 vorgesehen.

Zur Erzeugung eines Bildes des Untersuchungsobjekts 5 mit Hilfe magnetischer Kernresonanz wird beispielsweise bei eingeschaltetem Z-Gradientenfeld das Hochfrequenzfeld eingeschaltet. Damit ist die Resonanzbedingung nur für eine Schicht im Untersuchungsobjekt erfüllt, so daß nur eine selektive Anregung der Kernspins in dieser Schicht erfolgt. Durch nachfolgendes Einschalten von X-und Y-Gradienten kann ein Bild für die Kernspinverteilung des Untersuchungsobjekts erhalten werden. Dies kann beispielsweise nach der Fourier-Transformationsmethode oder nach der Projektions-Rekonstruktionsmethode erfolgen. Beide Methoden sind beispielsweise in der europäischen Patentanmeldung 00 74 022 beschrieben.

Bei diesem bekannten Kernspin-Tomographiegerät muß die Hochfrequenzspule exakt abgeglichen werden.

Aufgabe der Erfindung ist es daher, ein Kernspin-Tomographiegerät der eingangs genannten Art so auszuführen, daß solche Abgleicharbeiten für die Messung des Kernresonanzsignals entfallen können.

Diese Aufgabe wird erfindungsgemäß dadurch gelöst, daß die Meßeinrichtung galvanisch mit dem Untersuchungsobjekt gekoppelt ist. Das Untersuchungsobjekt wird damit Teil der Empfangsantenne oder deren Zuleitung.

In einer vorteilhaften Ausführungsform wird nur ein zu untersuchender Teilbereich des Untersuchungsobjekts galvanisch angekoppelt.

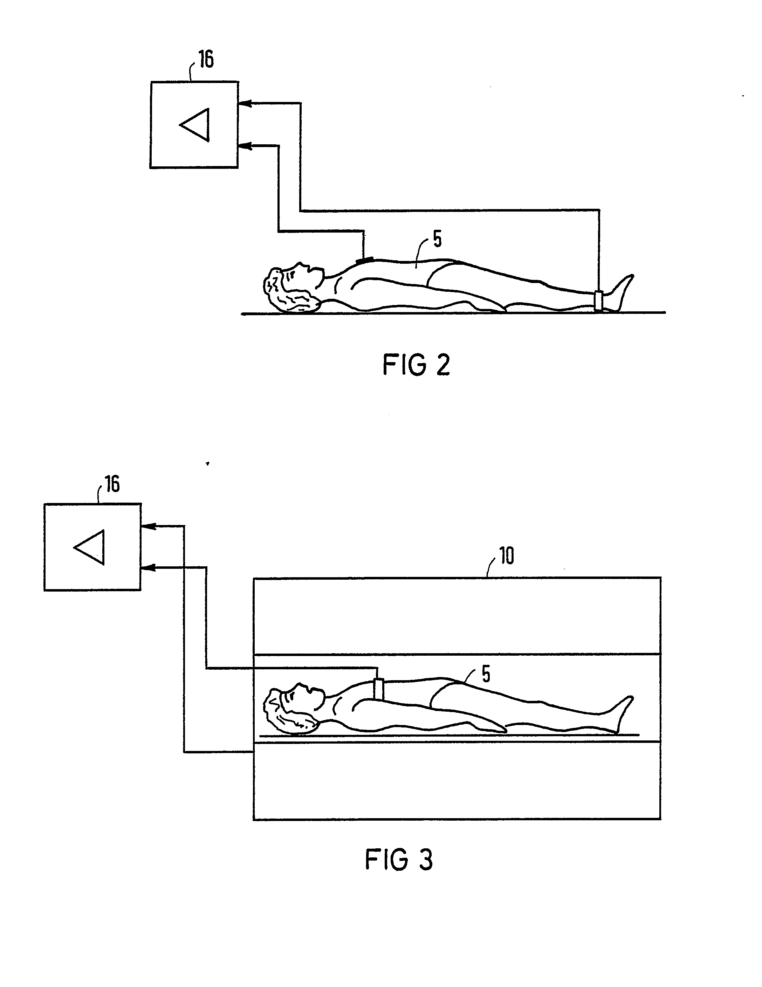

Ein in Fig. 2 schematisch dargestelltes Ausführungsbeispiel zeigt eine bipolare Ankopplung eines Untersuchungsobjekts 5, beispielsweise eines Menschen an den Signalverstärker 16. Dabei muß lediglich der Bereich des Untersuchungsobjekts 5 zwischen den beiden Anschlüssen liegen, der abgebildet werden soll.

Ansonsten können alle Teile des Geräts nach Fig. 1 übernommen werden. Auch die bekannten Bildrekonstruktionsverfahren können weiterhin angewandt werden. Dabei hat sich herausgestellt, daß mit der galvanischen Ankopplung Bilder erzeugt werden können, die denen mit induktiver Ankopplung über die Hochfrequenzspule 9 zumindest gleichwertig sind, wobei jedoch der Aufwand für den Abgleich der Hochfrequenzspule 9 für den Signalempfang entfällt.

Die Erfindung basiert darauf, daß das Kernresonanzsignal im Körper, der als Dielektrikum wirkt, elektromagnetische Felder erzeugt. Diese elektromagnetischen Felder und insbesondere die elektrische Komponente des Feldes werden dann gemäß der Erfindung galvanisch abgeleitet. Somit wird der Patient bei der Signalauswertung als Teil der Empfangsantenne benutzt.

Das Untersuchungsobjekt 5 kann auch gemäß der schematischen Darstellung nach Fig. 3 monopolar an den Signalverstärker 16 angekoppelt werden. Der zweite Pol des Signalverstärkers 16 ist in diesem Fall mit einem Massepotential der Untersuchungseinrichtung 10 verbunden.

## Ansprüche

Patentansprüche

1. Kernspin-Tomographiegerät zur bildlichen Darstellung von Bereichen aus dem Inneren eines Untersuchungsobjekts (5) mit Mitteln (1 bis 9) zum Anlegen von magnetischen Grund-und Gradientenfeldern an das Untersuchungsobjekt (5) und zur Auslenkung der Kernspins des Untersuchungsobjekts (5) aus ihrer Gleichgewichtslage durch hochfrequente Anregeimpulse sowie mit einer Meßeinrichtung (16, 17, 18) zur Erfassung der durch Spinpräzession erzeugten Signale,
**dadurch gekennzeichnet,**
daß die Meßeinrichtung galvanisch mit dem Untersuchungsobjekt (5) gekoppelt ist.

2. Kernspin-Tomographiegerät nach Anspruch 1,
**dadurch gekennzeichnet,**
daß nur ein zu untersuchender Teilbereich des Untersuchungsobjektes (5) galvanisch angekoppelt wird.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 084 946 (TECHNICARE CORP.) <br> * Seite 1, Zeilen 1-22; Seite 18, Zeilen 26-30 * <br><br> --- | 1 | G 01 N 24/04 <br> G 01 N 24/08 |
| A | EP-A-0 132 785 (SIEMENS AG) <br> * Seite 1, Zeilen 7-17; Seite 4, Zeilen 6-9 * <br><br> --- | 1 | |
| A | EP-A-0 117 725 (KABUSHIKI KAISHA TOSHIBA) <br> * Seite 2, Zeile 28 - Seite 3, Zeile 11; Seite 6, Zeilen 4-14; Seite 7, Zeilen 2-33 * <br><br> --- | 1 | |
| A | EP-A-0 145 915 (BRUKER MEDIZINTECHNIK GmbH) <br> * Seite 7, Zeile 19 - Seite 9, Zeile 16 * <br><br> --- | 1 | RECHERCHIERTE SACHGEBIETE (Int. Cl.4) <br><br> G 01 N |
| A,D | DE-A-3 340 523 (SIEMENS AG) <br> * Seite 3, Zeilen 2-14 * <br><br> ----- | 1 | |

Der vorliegende Recherchenbericht wurde für alle Patentansprüche erstellt.

| Recherchenort | Abschlußdatum der Recherche | Prüfer |
|---|---|---|
| DEN HAAG | 12-06-1987 | HORAK G.I. |

EPA Form 1503 03 82

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument